# DEMANDE DE BREVET EUROPEEN

(11) **EP 1 271 157 A1**
(43) Date de publication de la demande: **02.01.2003**
(21) Numéro de dépôt: 02076810.7
(22) Date de dépôt: 07.05.2002
(51) Int. Cl.: G01R 1/067, G01R 1/073

(54) **Aiguilles pour cartes de test utilisées pour tester des dispositifs semi-conducteurs, procédé de fabrication et procédé de positionnement**

(30) Priorité: 28.06.2001 EP 01202494
(71) Demandeur: EM Microelectronic-Marin SA, 2074 Marin (CH)
(72) Inventeur: Bende, Gavril, 2014 Bôle (CH); Ramos, Francisco, 2000 Neuchâtel (CH)
(74) Mandataire: Laurent, Jean

(57) **Abrégé**

Il est décrit un appareil de test à aiguilles pour contrôler le bon fonctionnement de dispositifs semi-conducteurs (111) immédiatement après leur fabrication. Plus précisément, il est prévu d'équiper de tels systèmes avec des aiguilles (1) particulières, en ce qu'elles comportent au moins deux pointes (8, 9, 18, 29) à leur extrémité entrant en contact avec les plots de contact (2) desdits dispositifs semi-conducteurs pendant les phases de test. De cette manière, les tolérances existant sur les déformations subies par lesdites aiguilles pendant les tests sont supérieures à celles des aiguilles de l'art antérieur.

## Description

La présente invention concerne un dispositif de test, plus particulièrement une aiguille de test conductrice, susceptible d'être disposée sur un dispositif de test pour tester les caractéristiques électriques de dispositifs semi-conducteurs, dont une première extrémité est prévue pour être connectée à une piste de conduction électrique dudit dispositif de test et dont la seconde extrémité est susceptible de contacter des plots de contact desdits dispositifs semi-conducteurs lors desdits tests.

Un tel type de dispositifs de test est couramment utilisé par les fabricants de semi-conducteurs pour tester le bon fonctionnement de leurs produits finis tels que des "wafers".

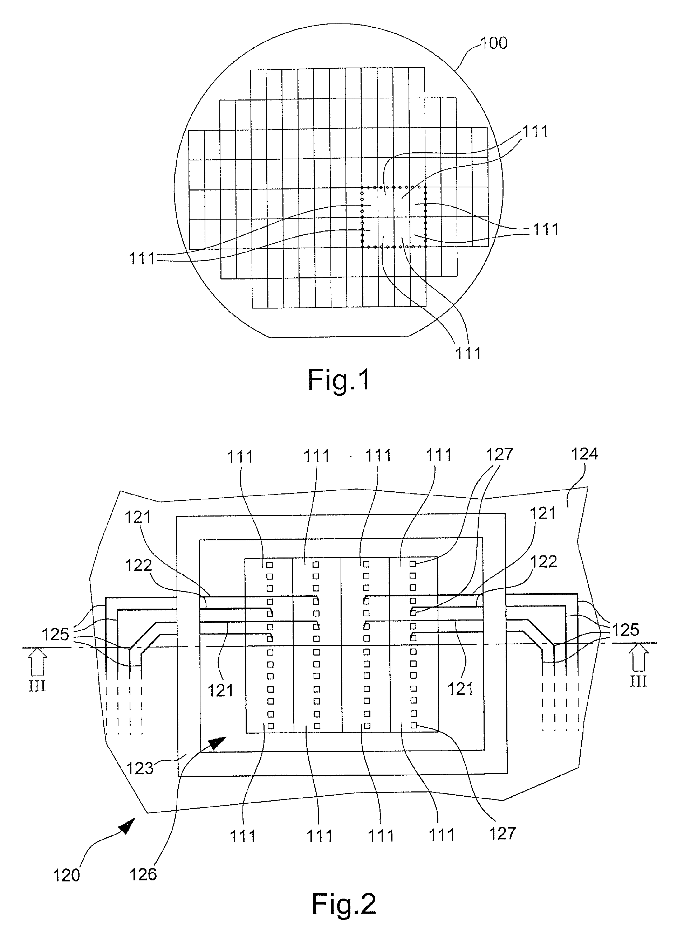

La figure 1 représente un exemple de ce type de dispositifs semi-conducteurs. On distingue en effet sur cette figure une plaquette à circuits intégrés, sur laquelle on va tester simultanément quatre colonnes, sur deux rangées, de circuits intégrés.

Sur la figure 1, la référence 100 désigne une plaquette de dispositifs semi-conducteurs comportant une pluralité de circuits intégrés 111.

La figure 2, qui est une vue agrandie des huit circuits intégrés référencés sur la figure 1, représente de manière schématique une phase de test. On y distingue un dispositif de test 120 disposé au-dessus de la plaquette 100. Ledit dispositif de test 120 comporte des aiguilles de test 121,122 connectées, via un support 123, mécaniquement à un substrat 124 généralement en résine, et électriquement à des pistes de conduction électrique 125 portées par ledit substrat 124. Ces pistes de conduction électriques 125 servent à établir la liaison électrique entre les aiguilles de test 121, 122 et un circuit électronique de test (non représenté). Ledit substrat 124 comprend en outre une ouverture 126 à travers laquelle passent lesdites aiguilles 121, 122 de manière à contacter des plots de contacts 127, ménagés sur ladite plaquette 100 pour effectuer divers tests.

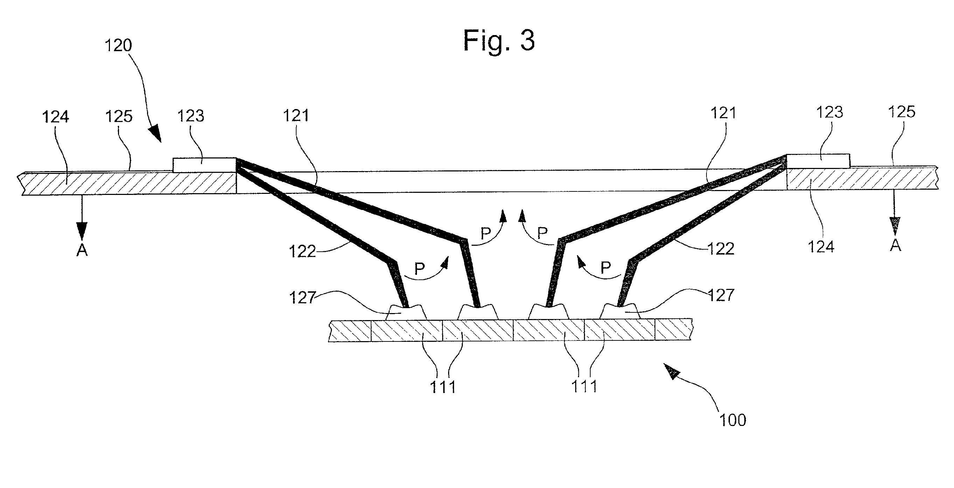

Les dispositifs de test décrits dans l'art antérieur présentent des inconvénients contraignants. En effet, pour effectuer les mesures de test, les aiguilles 121, 122 doivent être fixées sur le dispositif 120 avec une très grande précision. Typiquement, lesdites aiguilles sont initialement positionnées et fixées manuellement en fonction des positions des plots de contact 127, disposés sur les plaquettes à semi-conducteurs 100, ce qui constitue un travail laborieux. En outre, lors des tests, lesdites aiguilles 121, 122 sont soumises à des déformations successives plus ou moins grandes et qui peuvent être permanentes (non élastiques) lorsque les contacts sont établis avec lesdits plots, tel que représenté par les flèches notées P sur la figure 3 qui est une vue selon la coupe III-III de la figure 2. Ces pressions conduisent à des déformations des aiguilles, plus ou moins importantes en fonction de la section desdites aiguilles et des propriétés élastiques du matériau employé pour leur fabrication. En outre, tel que visible sur les figure 2 et 3, lorsque la densité des plots de contact 127 sur les plaquettes à semi-conducteurs à tester est élevée, il est nécessaire de prévoir plusieurs rangées d'aiguilles de test sur un même dispositif 120. De ce fait, certaines aiguilles 121 étant plus longues que d'autres 122, elles ne subissent pas les mêmes contraintes mécaniques sous l'effet de la pression exercée lors des tests et ne se déforment donc pas de la même façon.

Lorsque ces déformations atteignent une certaine amplitude, il y a un risque que les aiguilles 121, 122 ne soient plus alignées avec les plots 127 qu'elles doivent contacter. En outre, un rapide contrôle visuel de l'alignement n'est pas possible sans instrument optique étant données les faibles dimensions des aiguilles et des plots de contact. Par conséquent, ce type de cartes qui est cher à la fabrication est délicat et coûteux à l'utilisation.

Le brevet US 6,016,061 décrit une structure particulière d'aiguille de test dont l'extrémité comporte une pluralité de zones de contact, présentant chacune une surface de contact réduite par rapport à l'extrémité des aiguilles de test conventionnelles, en vue de limiter les dommages causés aux plages de contact testées. Cette structure d'aiguille ne permet pas aux différentes zones de contact de se déplacer les unes par rapport aux autres. Ainsi, au cours de leur utilisation, les différentes zones de contact se déforment toutes dans la même direction avec la même amplitude et cette solution ne permet pas de résoudre le problème décrit plus haut.

Des solutions ont été proposées dans l'art antérieur pour remédier à ces difficultés. La plus immédiate de ces solutions, qui est également loin d'être la plus intéressante, consiste à ne pas trop diminuer les dimensions des plots de contact sur les dispositifs semi-conducteurs par rapport aux dimensions des aiguilles. Cette disposition permet au fabricant d'avoir des tolérances plus importantes sur les déformations que peuvent subir les aiguilles pendant les étapes de test. Cette solution ne convient plus aux besoins actuels de l'industrie des semi-conducteurs, dont un des objectifs principaux est l'optimisation de l'espace utilisé pour la fabrication de ses produits et donc la réduction des dimensions des plots de contacts.

Une autre solution proposée consiste à recourir à une membrane plus ou moins rigide que traversent les aiguilles et permettant de maintenir les positions de leurs dites secondes extrémités. Le brevet US 5,055,778 décrit un tel dispositif utilisant une membrane en résine ou en silicone. Ladite membrane présente préférentiellement une certaine élasticité permettant d'absorber les déformations dues à la pression de contact des aiguilles sur des plots de contact de dispositifs semi-conducteurs à tester. Cette solution présente toutefois un inconvénient en ce que la structure de l'ensemble de la carte est particulière et plus complexe que celles de l'art antérieur, nécessitant la mise en place d'un procédé de fabrication différent de ceux existants. En outre, ladite structure limite la compatibilité des composants avec les composants classiques utilisés sur d'autres cartes de test déjà disponibles sur le marché.

La présente invention a donc pour but principal de pallier les inconvénients de l'art antérieur susmentionnés en fournissant une aiguille de test adaptable sur les cartes de test existantes pour tester des dispositifs semi-conducteurs, présentant notamment une bonne tenue dans le temps de son positionnement par rapport aux plots de contact desdits dispositifs semi-conducteurs. Ceci permet avantageusement de conserver un contact fiable avec les plots en dépit des éventuelles déformations subies par les aiguilles.

A cet effet, l'invention a pour objet une aiguille de test du type mentionné plus haut, caractérisée par le fait que ladite aiguille comporte, dans le sens de sa seconde vers sa première extrémité, au moins deux branches solidaires d'une même portion formant tige et susceptibles de contacter simultanément un même plot de contact par leurs extrémités libres terminées en pointes, les branches et la tige formant un conducteur électrique unique.

De ce fait, la probabilité que l'aiguille selon l'invention contacte le plot de contact souhaité sur le dispositif semi-conducteur est plus grande que dans le cas des aiguilles de l'art antérieur, notamment après que celles-ci ont subi d'éventuelles déformations. En effet, comme cela a déjà été signalé plus haut, pendant les tests de dispositifs semi-conducteurs les aiguilles de test ont tendance à se déformer du fait de la pression qu'elles subissent. Avec une aiguille du type de celles connues de l'art antérieur, lorsque l'amplitude des déformations atteint une certaine valeur il se peut que ladite aiguille ne soit plus positionnée correctement par rapport au plot de contact qu'elle doit contacter. Avec une aiguille selon l'invention, pour la même amplitude des déformations, il se peut également que l'une desdites au moins deux pointes ne soit plus positionnée correctement. Cependant, la seconde pointe étant initialement positionnée à un endroit du plot différent de l'endroit contacté par la première pointe, la probabilité est grande que ladite seconde pointe soit encore positionnée correctement pour contacter ledit plot souhaité. On peut noter que, lesdites deux pointes étant reliées électriquement l'une à l'autre directement au niveau de l'aiguille de test, il y a équivalence du point de vue d'un test si le contact avec un plot du dispositif semi-conducteur à tester est établi respectivement par la première ou par la seconde desdites deux pointes.

Par conséquent, alors qu'une aiguille selon l'art antérieur nécessite une opération de maintenance, l'aiguille selon la présente invention remplit encore sa fonction correctement. La période séparant deux opérations de maintenance successives se trouvant augmentée par rapport à celle de l'art antérieur, l'intérêt économique de l'aiguille de test selon l'invention est évident.

En outre, les tolérances admises sur les déformations des aiguilles selon l'invention étant plus grandes que dans le cas des aiguilles de l'art antérieur, le fabricant de dispositifs semi-conducteurs peut réduire la taille des plots de contact qu'il réalise sur lesdits dispositifs.

L'invention a également pour objet plusieurs procédés de fabrication de ladite aiguille de test, permettant par des méthodes différentes d'obtenir une aiguille de test dont ladite seconde extrémité comporte au moins deux pointes.

Un premier procédé comporte les étapes consistant à:
a. obtenir ou fabriquer deux éléments longilignes en matériau conducteur électrique,
b. ajuster éventuellement la section desdits éléments longilignes, par une opération du type tréfilage, pour obtenir la section souhaitée,
c. lier partiellement lesdits éléments longilignes dans le sens de leur longueur, par une opération de soudure, de brasage ou de collage à l'aide d'une colle électriquement conductrice, à partir d'une première de leurs extrémités respectives de façon à définir ladite tige, leurs extrémités libres respectives étant maintenues disjointes de façon à définir lesdites deux branches.

Un autre procédé proposé conformément à la présente invention comporte les étapes consistant à:
a. obtenir ou fabriquer une feuille en matériau conducteur électrique dont l'épaisseur correspond sensiblement au diamètre souhaité pour ladite aiguille de test,
b. découper ladite aiguille directement dans ladite feuille par découpage laser, par voie chimique ou par photogravure, de manière que ladite tige et lesdites branches sont réalisées d'une seule pièce.

L'invention a également pour objet un procédé de positionnement d'aiguilles de test, selon la présente invention, sur une carte de test et relativement aux positions de plots de contact disposés sur un dispositif semi-conducteur à tester avant de commencer lesdits tests.

La structure et les procédés selon l'invention permettent donc avantageusement d'effectuer le test de séries de dispositifs semi-conducteurs, généralement des circuits intégrés conditionnés en plaquette, tout en augmentant la durée séparant deux contrôles et réglages successifs des positions des aiguilles par rapport aux dispositifs de l'art antérieur.

L'invention sera mieux comprise à l'aide de la description suivante d'un exemple d'exécution en référence aux dessins annexés dans lesquels:
- la figure 1, déjà décrite plus haut, représente de manière schématique une vue en élévation d'une plaquette de dispositifs semi-conducteurs;
- la figure 2, déjà décrite plus haut, représente une vue en élévation schématique de ladite plaquette, au-dessus de laquelle on a disposé un appareil de test, dont une partie seulement est représentée, comportant des aiguilles de test selon l'art antérieur;
- la figure 3, également déjà décrite plus haut, représente une vue schématique en coupe selon la ligne III-III de la figure 2, sur laquelle certaines desdites aiguilles de test selon l'art antérieur sont représentées alors qu'elles entrent en contact avec des plots de contact desdits dispositifs semi-conducteurs;
- la figure 4 est une vue en perspective schématique agrandie d'une aiguille selon la présente invention positionnée au dessus d'un plot de contact d'un dispositif semi-conducteur;
- la figure 5 est une vue similaire à celle de la figure 4 où l'aiguille est fabriquée selon un autre mode de réalisation de la présente invention;
- la figure 6 est une vue schématique en élévation d'un plot de contact sur lequel ont été représentées les projections de deux pointes d'une aiguille selon la présente invention avant le début des phases de tests.

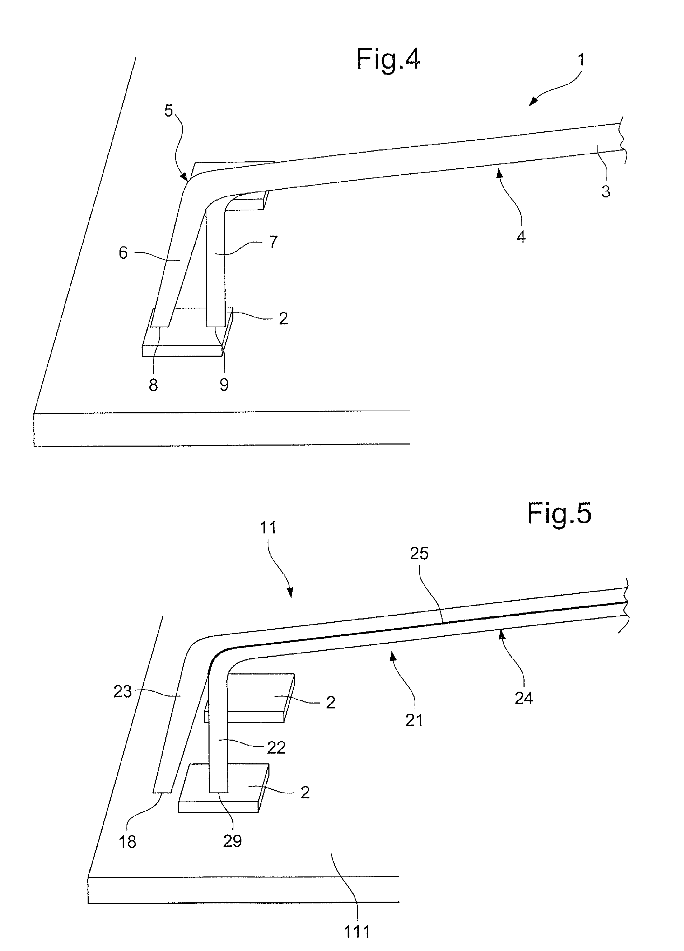

Une aiguille 1 présentant une structure selon l'invention est représentée sur la figure 4, alors qu'elle entre en contact avec un plot de contact 2 d'un dispositif semi-conducteur 111.

Une première extrémité 3 de ladite aiguille est typiquement reliée à une carte de test par le biais d'un anneau-support en résine (non représenté). Cet aspect ne sera pas développé ici plus en détails dans la mesure où il fait partie des connaissances générales de l'homme de l'art, de même que la structure détaillée de ladite carte de test qui est de type conventionnel.

Partant de ladite première extrémité 3, l'aiguille 1 comporte une première portion 4 sensiblement rectiligne se terminant par une portion courbée 5, le tout définissant une tige. A partir de ladite portion courbée 5 s'étendent deux branches sensiblement rectilignes 6 et 7, présentant des angles respectifs différents par rapport à ladite première portion rectiligne 4. Lesdites deux branches rectilignes 6, 7 définissent ainsi deux pointes 8 et 9, situées sensiblement dans un même plan horizontal, susceptibles de contacter les plots de contact 2 de dispositifs semi-conducteurs 111.

Typiquement, les aiguilles de test selon l'invention sont réalisées avec des matériaux couramment utilisés dans l'art antérieur, tels que le tungstène ou encore un alliage de cuivre-béryllium (CuBe).

En ce qui concerne la fabrication desdites aiguilles, plusieurs méthodes sont envisageables. On peut tout d'abord adapter un procédé habituellement utilisé pour fabriquer les aiguilles de test de l'art antérieur, c'est-à-dire réaliser un fil métallique de section voulue par une opération de tréfilage, effectuer une découpe à l'une des extrémités dudit fil dans le sens de sa longueur de façon à obtenir deux branches puis courber ou plier lesdites deux branches avec des angles respectifs différents, préférentiellement légèrement inférieurs à 90 degrés. On peut bien sûr imaginer que, par exemple, l'angle appliqué à l'une desdites deux branches est inférieur à 90 degrés tandis que l'angle appliqué à la seconde desdites branches est légèrement supérieur à 90 degrés.

On peut également fabriquer de telles aiguilles de test en partant d'une feuille métallique d'épaisseur correspondant à la section voulue pour l'aiguille, ladite feuille étant découpée selon le profil de l'aiguille de test de façon à obtenir directement ladite aiguille sans opération supplémentaire. Ledit découpage peut être réalisé, par exemple, par gravure laser, par voie chimique, ou par un procédé de photogravure.

Deux méthodes supplémentaires envisageables pour la réalisation desdites aiguilles consistent à faire appel à des procédés de soudure, de brasage ou de collage à l'aide d'une colle électriquement conductrice. On peut, d'une part, partir d'une aiguille de test telle que connue de l'art antérieur sur laquelle on fixe une seconde branche 7 au niveau de l'extrémité recourbée, définissant ainsi une seconde pointe 9, tel que représenté sur la figure 4, par l'une des méthodes susmentionnées. On peut, d'autre part en se référant à la figure 5, partir de deux aiguilles 11, 21 telles que connues de l'art antérieur et préférentiellement de sections plus faibles que les sections usuelles, que l'on fixe l'une à l'autre, par l'une des méthodes susmentionnées. La jonction effectuée entre lesdites deux aiguilles 11 et 21 est désignée par la référence 25 sur la figure 5.

Dans ce dernier cas, une première desdites aiguilles 21 est choisie plus courte que l'autre 11 et sa branche 22, portant la pointe 29 qui est susceptible d'être mise en contact avec des plots de contact 2 pendant les tests, est recourbée ou pliée d'un angle plus important, par rapport à la première portion rectiligne 24, que la branche 23, portant la pointe 18, correspondante de la seconde desdites aiguilles 11. De cette manière, lesdites branches respectives 22, 23 desdites aiguilles 11, 21 sont disjointes et l'ensemble obtenu définit ainsi une seule aiguille comportant deux pointes 18, 29.

En outre et conformément à l'invention l'écartement entre lesdites deux branches 22, 23 est déterminé à partir des dimensions des plots de contact 2 à tester, de façon que lesdites deux pointes 18, 29 puissent initialement contacter simultanément un même plot de contact 2 du dispositif semi-conducteur.

Comme on l'a signalé précédemment, pendant les tests de dispositifs semi-conducteurs, les aiguilles de test subissent des pressions plus ou moins importantes qui entraînent leur déformation. En effet, les aiguilles sont positionnées sur une carte de test par le biais d'un support de façon que leurs extrémités, qui sont susceptibles de contacter les plots de contact, soient sensiblement situées dans un même plan horizontal. La carte est alors généralement approchée des dispositifs semi-conducteurs à tester du haut vers le bas (représenté par les flèches A sur la figure 3) jusqu'à ce que les aiguilles entrent en contact avec lesdits plots. Toutefois, les plots de contact sur les dispositifs semi-conducteurs ont des hauteurs variables, c'est pourquoi la carte de test est abaissée plus que nécessaire a priori, pour s'assurer que toutes les aiguilles établissent effectivement un contact avec le plot de contact correspondant sur le dispositif semi-conducteur à tester. De ce fait, les aiguilles de test subissent une pression plus ou moins importante en fonction de la hauteur réelle du plot de contact correspondant. Lesdites aiguilles ont, par conséquent, tendance à se déformer et à transmettre ladite pression à la carte de test, qui est donc également susceptible de se déformer pour finalement présenter un défaut de planéité. Le fait que la carte de test est abaissée plus près du dispositif semi-conducteur que nécessaire a priori a également pour but de compenser les déformations progressives des aiguilles et de la carte de test.

Lorsqu'on s'intéresse plus précisément aux déformations subies par les aiguilles de test, on constate qu'elles peuvent entraîner l'établissement d'un mauvais contact avec le plot correspondant, voire même l'absence de contact.

C'est pourquoi, comme cela est apparent de la figure 5, lorsque l'aiguille de test selon l'invention se déforme jusqu'à ce que l'une des deux pointes 18 ne puisse plus contacter le plot 2 correspondant, la seconde pointe 29 garantit encore le contact. On peut en effet considérer qu'en première approximation, d'après la structure de l'aiguille selon l'invention, ladite première pointe 18 correspond à la pointe unique d'une aiguille de l'art antérieur. Ainsi, lorsqu'une aiguille de l'art antérieur se déforme au point de nécessiter une opération de maintenance fastidieuse, l'aiguille selon la présente invention peut encore fonctionner correctement grâce à la présence de ladite seconde pointe 29.

On peut noter qu'en outre, du fait de la distance séparant la jonction des branches de leurs pointes respectives, les branches sont susceptibles de se déformer différemment l'une de l'autre, c'est-à-dire dans des directions différentes et avec des amplitudes de déformations respectives différentes. Ainsi, lorsque l'une des pointes 18 ou 29 subit une déformation importante, par exemple au point de ne plus être alignée avec le plot de contact qu'elle doit tester, il est possible que l'autre pointe ne se déforme pas ou que très peu et soit toujours alignée avec ledit plot de contact. Cette caractéristique particulière est intéressante du point de vue des coûts d'utilisation, car elle permet statistiquement de prolonger la période séparant deux opérations de maintenance successives des aiguilles de test selon la présente invention par rapport aux aiguilles de l'art antérieur.

Partant de ce principe, on peut en déduire une méthode d'optimisation du positionnement initial de l'aiguille 1 selon l'invention, c'est-à-dire avant le début des tests et donc des déformations, sur la carte de test (figure 4). Pour ce faire, il faut tenir compte des dimensions et de la position du plot de contact 2 correspondant sur le dispositif semi-conducteur à tester. Comme cela a déjà été mentionné, l'écartement entre les deux branches 6, 7 de l'aiguille 1 selon l'invention dépend également des dimensions des plots à tester.

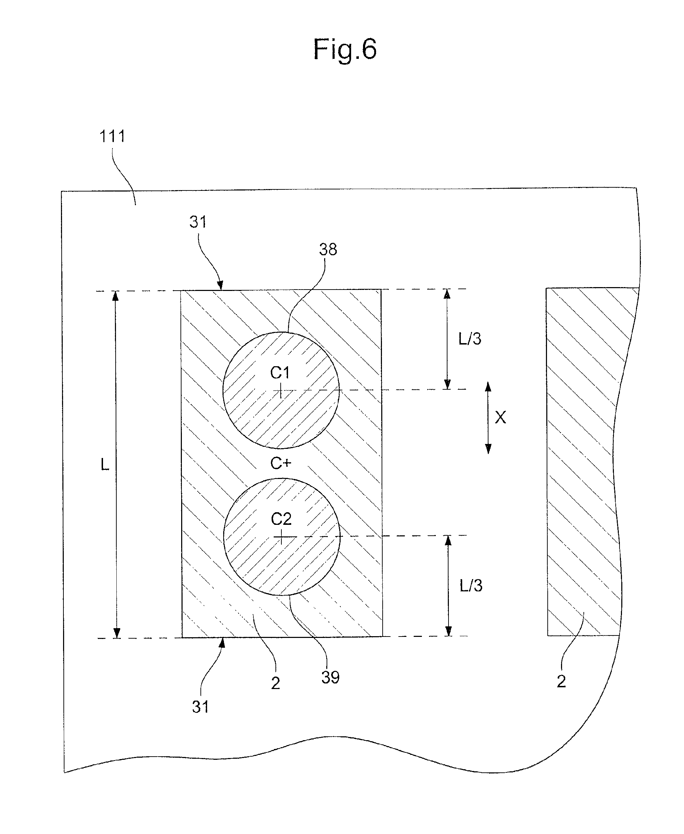

On a représenté sur la figure 6 une vue de dessus d'un plot de contact 2 sur lequel sont schématisées les projections orthogonales 38, 39 desdites pointes 8, 9 de l'aiguille 1 selon l'invention. On peut dire que, d'une certaine manière, les pointes 8, 9 doivent être préférentiellement centrées sur le plot de contact 2, dans la mesure où la direction des déformations est aléatoire, tant pour l'aiguille que pour chacune de ses branches. En effet, la seule tendance qui se dégage de la pratique indique que les déformations les plus importantes ont principalement lieu dans la direction représentée par la double flèche référencée par X sur la figure 6.

Ainsi dans le cas d'un plot de contact 2 de forme sensiblement rectangulaire de longueur notée L sur la figure 6, choisie ici à titre d'exemple non limitatif, on positionnera préférentiellement l'aiguille de test de manière que le centre C1 de ladite projection 38 d'une première des pointes 8 est situé sensiblement à une distance L/3 du petit côté 31 du plot 2 le plus proche de ladite pointe 8. Par conséquent, l'écartement ménagé entre lesdites deux pointes 8, 9 de l'aiguille 1 sera préférentiellement choisi de manière que le centre C2 de ladite projection 39 de la seconde desdites pointes 9 est également situé à une distance L/3 de l'autre petit côté 31 dudit plot 2 de contact. Autrement dit, le centre du segment défini par C1 et C2 coïncide préférablement avec le centre géométrique C du plot de contact. Cette configuration présentant la plus grande garantie de contact entre l'aiguille et les plots successifs correspondants dans le temps, elle constitue un mode de réalisation préféré pour le procédé de positionnement de l'aiguille sur une carte de test selon l'invention.

On peut noter que, grâce à la présente invention, un fabricant de dispositifs semi-conducteurs peut avantageusement diminuer les dimensions des plots de contact ménagés sur lesdits dispositifs et ainsi diminuer la taille globale desdits dispositifs. Cette diminution permet audit fabricant d'utiliser moins de matière première pour la fabrication desdits dispositifs, ce qui constitue un avantage principal de la présente invention.

La description qui précède correspond à des modes de réalisation préférés de l'invention et ne saurait en aucun cas être considérée comme limitative, en ce qui concerne plus particulièrement la forme, l'inclinaison et les matériaux décrits pour l'aiguille de test, les procédés de fabrication et la forme des plots de contact décrite.

## Revendications

1. Appareil de test, pour tester les caractéristiques électriques de dispositifs semi-conducteurs (111), comportant un substrat isolant portant des pistes de conduction électrique reliées d'une part à un circuit électronique de test et d'autre part à des terminaisons électriques situées sur ledit substrat, un support prévu pour être disposé sur ledit substrat et auquel sont liées mécaniquement et électriquement une pluralité d'aiguilles de test (1) par une première (3) de leurs extrémités respectives, ledit support comportant des connecteurs électriques prévus pour relier lesdites premières extrémités (3) d'aiguilles (1) auxdites terminaisons électriques dudit substrat, les secondes extrémités respectives desdites aiguilles (1) étant prévues pour contacter des plots de contact (2) ménagés sur lesdits dispositifs semi-conducteurs (111), **caractérisé en ce que** chacune desdites aiguilles (1) comporte, dans le sens de sa seconde vers sa première extrémité (3), au moins deux branches (6, 7, 22, 23) solidaires d'une même portion formant tige (4, 24) et susceptibles de contacter simultanément un même plot de contact (2) par leurs extrémités libres terminées en pointes (8, 9, 18, 29), les branches (6, 7, 22, 23) et la tige (4, 24) formant un conducteur électrique unique.

2. Aiguille de test conductrice (1), susceptible d'être disposée sur un appareil de test, notamment selon la revendication 1, pour tester les caractéristiques électriques de dispositifs semi-conducteurs (111), prévue pour être liée mécaniquement et électriquement à un support dudit appareil de test par une première extrémité (3), la seconde extrémité étant prévue pour contacter des plots de contact (2) ménagés sur lesdits dispositifs semi-conducteurs (111), **caractérisée en ce qu'**elle comporte, dans le sens de sa seconde vers sa première extrémité (3), au moins deux branches (6, 7, 22, 23) solidaires d'une même portion formant tige (4, 5, 24) et susceptibles de contacter simultanément un même plot de contact (2) par leurs extrémités libres terminées en pointes (8, 9, 18, 29), les branches (6, 7, 22, 23) et la tige (4, 5, 24) formant un conducteur électrique unique.

3. Aiguille de test selon la revendication 2, **caractérisée en ce que** ladite tige (4, 5, 24) comporte au moins une portion sensiblement rectiligne.

4. Aiguille de test selon la revendication 2 ou 3, **caractérisée en ce que** ladite tige (4, 5, 24) comporte, à partir de ladite première extrémité (3), une première portion sensiblement rectiligne (4, 24) suivie d'une portion courbée (5) suivie desdites deux branches (6, 7, 22, 23) sensiblement rectilignes plus courtes que ladite tige (4, 5, 24), présentant des angles respectifs différents par rapport à ladite tige de façon à définir deux pointes (8, 9, 18, 29) distinctes en leurs extrémités libres respectives.

5. Aiguille de test selon l'une des revendications 2 à 4, **caractérisée en ce qu'**en partant de ladite première extrémité (3) d'aiguille (1), ladite tige (4, 5, 24) comporte deux éléments longilignes (11, 21) de faibles sections partiellement soudés, brasés ou collés à l'aide d'une colle électriquement conductrice dans le sens de la longueur, leurs parties libres respectives étant disjointes de façon à définir lesdites deux branches (22, 23).

6. Aiguille de test selon l'une des revendications 2 à 5, **caractérisée en ce qu'**en cours d'utilisation, lesdites branches (6, 7, 22, 23) sont susceptibles de subir des déformations respectives différentes.

7. Procédé de fabrication d'une aiguille de test (1) conformément aux revendications 2 à 4, comportant les étapes consistant à:
a. se munir d'un fil en matériau conducteur électrique ayant une section déterminée;
b. couper ledit fil, à partir d'une de ses extrémités, sur une partie de sa longueur de façon à obtenir lesdites deux branches (6, 7, 22, 23) de sections sensiblement identiques, tandis que la partie non coupée dudit fil forme ladite tige (4, 5, 24);
c. plier lesdites deux branches (6, 7, 22, 23) avec des angles respectifs différents par rapport à ladite tige.

8. Procédé de fabrication d'une aiguille de test (1) conformément aux revendications 2 à 6, comportant les étapes consistant à:
a. se munir de deux éléments longilignes (11, 21) en matériau conducteur électrique ayant une section déterminée,
b. lier partiellement lesdits éléments longilignes dans le sens de leur longueur, à partir d'une première de leurs extrémités respectives (3) de façon à définir ladite tige (4, 5, 24) et à réaliser un contact électrique (25) entre eux, leurs extrémités libres respectives étant maintenues disjointes de façon à définir lesdites deux branches (6, 7, 22, 23).

9. Procédé de fabrication d'une aiguille de test (1) selon la revendication 8, **caractérisé en ce que** dans l'étape b, la liaison desdits éléments longilignes (11, 21) est effectuée par une opération de soudure, de brasage ou de collage à l'aide d'une colle électriquement conductrice.

10. Procédé de fabrication d'une aiguille de test (1) conformément aux revendications 2 à 4, comportant les étapes consistant à:
a. se munir d'une feuille en matériau conducteur électrique dont l'épaisseur correspond sensiblement au diamètre souhaité pour ladite aiguille de test (1),
b. découper ladite aiguille (1) directement dans ladite feuille de manière que ladite tige (4, 5, 24) et lesdites branches (6, 7, 22, 23) sont réalisées d'une seule pièce.

11. Procédé de fabrication d'une aiguille de test (1) selon la revendication 10, **caractérisé en ce que** ladite étape b de découpage est effectuée par découpage laser, par voie chimique ou par photogravure.

12. Procédé de positionnement, sur un appareil de test, d'aiguilles de test (1) conformément à l'une des revendications 2 à 6, ledit appareil de test comportant un substrat isolant portant des pistes de conduction électrique reliées d'une part à un circuit électronique de test et d'autre part à des terminaisons électriques situées sur ledit substrat, ledit appareil comportant en outre un support prévu pour être disposé sur ledit substrat et auquel sont liées mécaniquement et électriquement une pluralité desdites aiguilles de test (1) par une première (3) de leurs extrémités respectives, ledit support comportant des connecteurs électriques prévus pour relier lesdites premières extrémités (3) desdites aiguilles (1) auxdites terminaisons électriques dudit substrat, les secondes extrémités respectives desdites aiguilles (1) comportant chacune au moins deux branches (6, 7, 22, 23) dont les extrémités en pointes (8, 9, 18, 29) sont prévues pour contacter des plots de contact (2) ménagés sur lesdits dispositifs semi-conducteurs (111), **caractérisée en ce qu'**on positionne lesdites au moins deux branches (6, 7, 22, 23) de chacune desdites aiguilles (1), avant le début des tests, de façon que lesdites branches (6, 7, 22, 23) contactent simultanément un même plot de contact (2) par leurs pointes (8, 9, 18, 29).

13. Procédé de positionnement selon la revendication 12, **caractérisé en ce qu'**on positionne lesdites au moins deux branches (6, 7, 22, 23) de chacune des aiguilles de test (1) de façon à ce que le centre géométrique des projections (38, 39) desdites au moins deux pointes (8, 9, 18, 29) sur ledit plot de contact (2) testé coïncident avec le centre géométrique (C) dudit plot de contact (2) testé.
